# EUROPEAN PATENT SPECIFICATION

(11) **EP 2 028 763 B1**
(45) Date of publication and mention of the grant of the patent: **18.04.2012**
(21) Application number: 08014780.4
(22) Date of filing: 20.08.2008
(51) Int. Cl.: H03J 1/00, H04B 1/16

(54) **A semiconductor device for use in radio tuner and method for manufacturing the same**
Halbleitervorrichtung für einen Radiotuner und Herstellungsverfahren dafür
Dispositif semi-conducteur à utiliser dans un syntoniseur de radio et son procédé de fabrication

(30) Priority: 21.08.2007 JP 2007215296
(43) Date of publication of application: 25.02.2009
(73) Proprietor: Sanyo Electric Co., Ltd., Osaka (JP); Sanyo Semiconductor Co., Ltd., Ora-gun Gunma (JP)
(72) Inventor: Kobayashi, Keiji, Ora-gun Gunma (JP); Sasaki, Fumihiro, Ora-gun Gunma (JP)
(74) Representative: Winter, Brandl, Fürniss, Hübner, Röss, Kaiser, Polte - Partnerschaft

(56) References cited:
- EP-A1- 1 376 866
- WO-A2-01/22583
- WO-A2-01/97512
- US-A- 5 678 211
- US-A1- 2002 065 056
- US-B1- 6 438 361

## Description

### 1. Field of the Invention

The present invention relates to a semiconductor device for use in a radio tuner and a method for manufacturing the same, and specifically relates to an integrated circuit (IC) that constitutes a radio tuner system.

### 2. Description of the Related Art

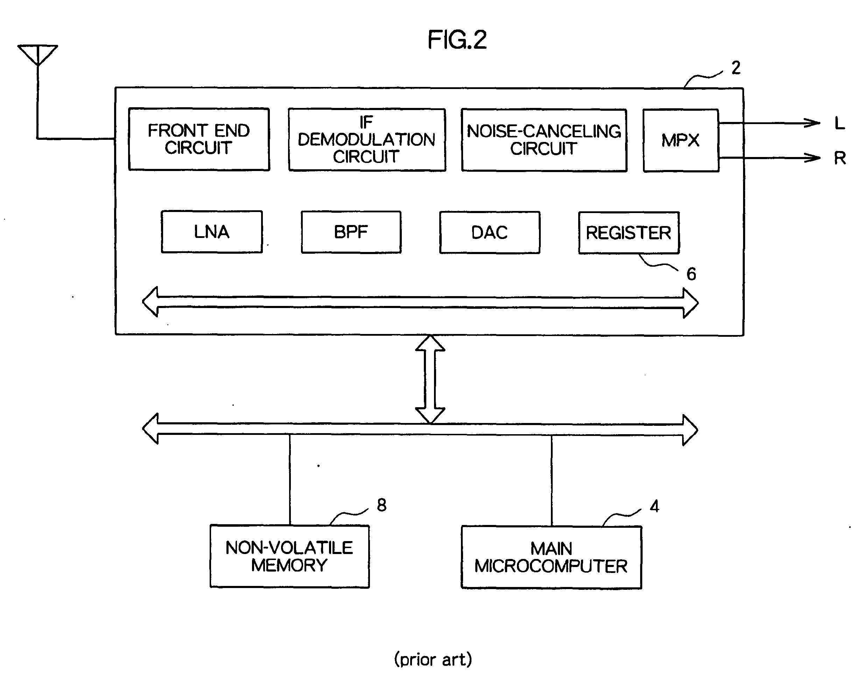

FIG. 2 is a schematic diagram showing the construction of a conventional radio tuner. In a conventional radio tuner, a tuner IC 2 that includes the main part of the tuner body, a main microcomputer 4 that has a function of controlling the tuner IC 2, and an EEPROM or other nonvolatile memory 8 are mounted on a printed substrate or other appropriate substrate. The tuner IC 2 has a register 6, and a variety of operations of the tuner can be adjusted in response to data that is one bit or other magnitude in size and is set in the register 6. Therefore, data stored in the register 6 will be essentially lost as a result of the electrical current being switched off. Some data may be rewritten when the operations are being performed. Therefore, data for attaining a suitable state of operation when the tuner is started is stored in an EEPROM or other nonvolatile memory 8 , read from the memory 8 when the tuner is started, and set in the register 6 of the tuner IC 2 from the main microcomputer 4 via a bus or other component. For example, the RF tuning precision, the sensitivity required for stopping at stations when a seek is performed (station detection sensitivity), the S-meter output characteristics, the IF amplifier gain, the degree of stereo separation, and other parameters can be adjusted based upon the data stored in the register 6.

An IC formed by a bipolar process can lower the upper-bound frequency of flicker noise band to a greater degree than an IC formed by a CMOS process, and therefore the tuner IC 2 is mainly formed by a bipolar process. In particular, when the AM radio tuner IC 2 is formed using CMOS, the IC 2 will be affected by CMOS flicker noise of up to 1 MHz, and sensitivity cannot be guaranteed. Therefore the IC 2 has an entirely bipolar construction.

Conventionally, the data preset to the register 6 of the tuner IC 2 is recorded into the memory 8 which is an IC that is different from the tuner IC 2. The data is written into the memory 8 when the manufacturer of the audio set or tuner mounts the tuner IC 2, the main microcomputer 4, and the memory 8 on a substrate and assembles the radio tuner. The work of adjusting the radio tuner assembled by the set manufacturer or tuner manufacturer with preset data written to the memory 8 involves a considerable number of preset items; therefore, problems are presented in that labor is required and production costs are caused to increase. The equipment used to perform the adjustments is typically of a construction wherein an all-purpose measuring instrument is controlled by a microcomputer, a GPIB, or the like. In other words, in contrast with a case in which a semiconductor tester capable of controlling IC operations at high speed is used to perform the adjustments, a problem has arisen in that productivity in the adjustment step is difficult to improve, even though the adjustment equipment can be built with little expense.
[Patent Document 1] Japanese Laid-open Patent Application No. 9-181630

Document EP 1 376 866 A1 describes a tuner which is provided with identifiers for identifying database fields in databases situated outside receivers so that calibration signals resulting from calibration processes can be downloaded for calibrating the electronically tuned filter of the tuner after installment in a receiver and without the tuner requiring any memory. The receiver comprises a receiver memory located outside the tuner for storing the calibration signal after downloading, and the database is coupled to a network, wherein the receiver comprises an in/output to be coupled to the network and the database is a server. The tuner comprises a digital-to-analog converter for converting the digital calibration signal into an analog calibration signal.

Document WO 01/22583 A2 discloses a television control system with modular tuner compatibility, comprising a tuner module coupled to a microprocessor via a communication bus. The tuner module includes a memory unit having tuner alignment data. The microprocessor communicates a tuning command via the communication bus to the tuner module and the tuner module locates the tuner alignment data corresponding to a desired television signal in the memory unit for performing electronic tuner alignment.

The present invention was contrived in order to resolve the afore described problems, and it is an object thereof to provide an IC for use in a radio tuner system, which is capable of reducing production costs and improving productivity for audio set manufacturers and tuner manufacturers, and a method for manufacturing the same.

The object is solved by the features of the independent claims. The dependent claims are directed to preferred embodiments of the invention.

The semiconductor device for use in a radio tuner according to the present invention is one in which a radio tuner part and a controller for controlling an operation of the radio tuner part are built in a single semiconductor package; the radio tuner part has an adjustment register for adjusting a predetermined function of the radio tuner part according to stored data; and the controller has a memory for pre-recording preset data for the adjustment register, and a control part for reading out the preset data from the memory at the start of operation of the radio tuner part and for storing the data in the adjustment register.

The method for manufacturing a semiconductor device for use in a radio tuner according to the present invention is a method for manufacturing the above-described semiconductor device, and has a packaging step for building the radio tuner part and the controller into the semiconductor package; and a finished goods inspection step for performing, after the packaging step, a finished goods inspection for determining whether the semiconductor device operates satisfactorily or unsatisfactorily using a semiconductor tester; wherein the finished goods inspection step involves checking an operation of the semiconductor device, and the preset data being written to the memory, according to an electrical signal fed from the semiconductor tester to a terminal of the semiconductor package.

### BRIEF DESCRIPTION OF THE DRAWINGS

FIG. 1 is a schematic structural diagram of a radio tuner system according to an embodiment of the present invention; and
FIG. 2 is a schematic diagram showing the structure of a conventional radio tuner.

### DESCRIPTION OF THE PREFERRED EMBODIMENTS

There follows a description of embodiments of the present invention ("embodiments") made with reference to the accompanying drawings.

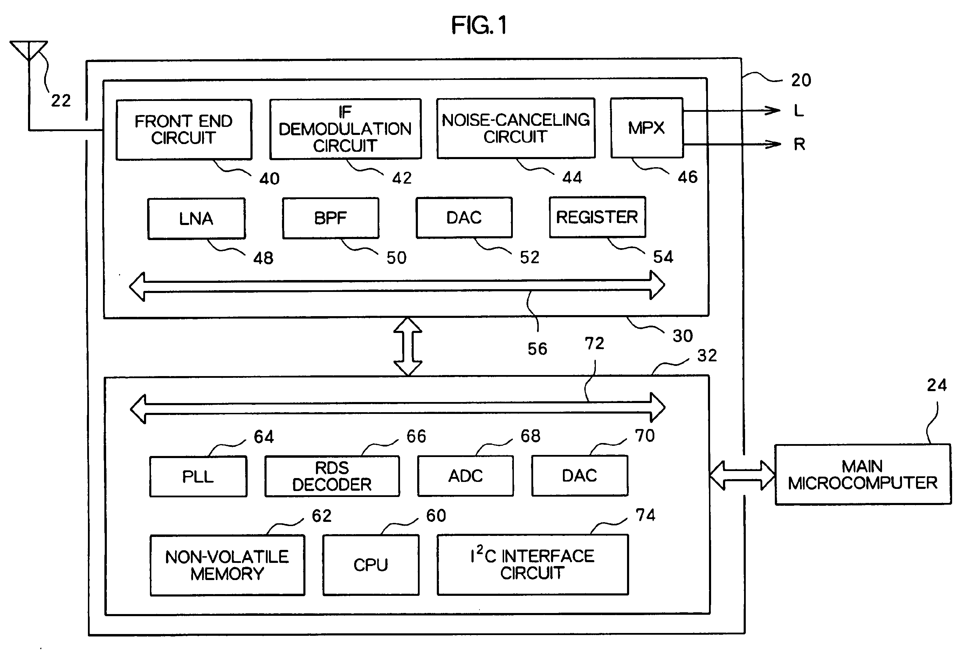

FIG. 1 is a schematic structural diagram of a radio tuner system according to an embodiment of the present invention. The system comprises a tuner system IC 20, an antenna 22, and a main microcomputer 24.

The tuner system IC 20 has a radio tuner part 30 and an electronic tuning control part (controller) 32. The radio tuner 30 and the electronic tuning control part 32 can be constructed on, e.g., separate semiconductor chips. The tuner system IC 20 stores the plurality of chips in one IC package, and the necessary wiring between the radio tuner part 30 and the electronic tuning control part 32 is provided inside the package. This hybrid IC construction is effective when the radio tuner part 30 is manufactured by a bipolar process or a BiCMOS process capable of lessening IC noise, and the electronic tuning control part 32 is manufactured by a CMOS process capable of low power consumption and other desirable properties in the IC. However, the radio tuner part 30 and the electronic tuning control part 32 built into the tuner system IC 20 may also be constructed on a single chip. This single-chip tuner system IC 20 may be directly surface-mounted on a printed circuit board without packaging.

The radio tuner part 30 is a circuit into which a radio frequency (RF) signal received by the antenna 22 is input, which extracts and detects a signal of a desired broadcasting station from the RF signal, and which produces an output. The radio tuner part 30 has a front end circuit 40, an IF demodulation circuit 42; a noise-canceling circuit 44; a multiplexer circuit (MPX) 46; a low-noise amplifier (LNA) 48; a band-pass filter (BPF) 50; a D/A (digital to analog) conversion circuit (DAC) 52; a register 54; and a bus 56.

The electronic tuning control part 32 has a CPU (central processing unit) 60, a nonvolatile memory 62, a PLL (phase locked loop) circuit 64, an RDS (radio data system) decoder 66, an A/D (analog to digital) conversion circuit (ADC) 68, a DAC 70, a bus 72, and an I²C (inter-integrated circuit) interface circuit 74.

The front end circuit 40 receives an oscillation signal generated by the PLL circuit 64, mixes the RF signal and a signal obtained by frequency-dividing the oscillation signal, and converts the received RF signal of the desired station to an IF (intermediate frequency) signal having an intermediate frequency. The IF demodulation circuit 42 demodulates the IF signal, which may be an AM signal or an FM signal. The noise-canceling circuit 44 has a function for eradicating pulse noise. When the FM modulation signal detected by the IF demodulation circuit 42 is a composite signal, the multiplexer circuit 46 extracts a difference signal (L-R) and a sum signal (L+R) that constitute the signal, separates the result into an L signal and an R signal from the difference signal and the sum signal by a matrix processing, and outputs a stereo signal comprising the L signal and the R signal. The LNA 48 amplifies, e.g., the RF signal with low noise. The BPF 50 e.g., variably constructs the passband; changes the passband width in response to the presence of proximity interference, the strength of the reception electric field, and other factors; and by so doing can reduce proximity interference and noise.

The register 54 is connected to the bus 56, and is made to store data via the bus 56. The register 54 can adjust the operation of each part inside the radio tuner part 30 described above in response to the data stored in the register. The operations in the circuits of each part are controlled in response to data expressed as a single bit or a plurality of bits. The DAC 52 converts the data stored in the register 54 to a voltage signal, and feeds the signal into the circuit to be controlled. For example, as previously stated, the RF tuning precision, the sensitivity required for stopping at stations when a seek is performed (station detection sensitivity), the S-meter output characteristics, the IF amplifier gain, the degree of stereo separation, and other parameters can be adjusted based upon the data stored in the register.

The CPU 60, for example, controls the operation of each part of the electronic tuning control part 32 via the bus 72, and, through the operations of each of these parts, controls the operation of the radio tuner part 30. The PLL circuit 64, under the control of the CPU 60, changes the frequency of the oscillation signal in response to the frequency of the desired station. The RDS decoder 66 extracts RDS information superimposed on the signal demodulated by the IF demodulation circuit 42. The I²C interface circuit 74 communicates with an external circuit using two external connecting terminals of the tuner system IC 20. For example, the main microcomputer 24 can control the electronic tuning control part 32 via the I²C interface circuit 74.

The nonvolatile memory 62 is connected to the bus 72. The nonvolatile memory 62 is, e.g., constructed as an EEPROM (electronically erasable and programmable read-only memory). The contents of the nonvolatile memory 62 can be rewritten by the signal received from a source that is externally disposed with respect to the tuner system IC 20. Data already written can be read out to the bus 72 under the control of the CPU 60.

The bus 56 of the radio tuner part 30 and the bus 72 of the electronic tuning control part 32 are interconnected. The CPU 60, e.g. when the tuner system IC 20 is activated, reads out the data recorded in the nonvolatile memory 62, and can perform the settings in the register 54.

A method for manufacturing the tuner system IC 20 will now be described. The tuner system IC 20 has a structure wherein the radio tuner part 30 to which the register 54 is provided and the electronic tuning control part 32 having the nonvolatile memory 62, which records data that has been preset in the register 54, are mounted in a single package. Therefore, suitable preset data in the register 54 of the radio tuner part 30 can be written to the nonvolatile memory 62 when the tuner system IC 20 is manufactured.

Specifically, on completion of a packaging step wherein the radio tuner part 30 and the electronic radio tuning control part 32 are built in a single semiconductor package, and the tuner system IC 20 is formed, the manufacturer uses a semiconductor tester to perform a finished goods inspection to determine whether the tuner system IC 20 operates satisfactorily or unsatisfactorily. Alternatively, in a case in which the tuner system IC 20 is surface-mounted as a semiconductor chip, the manufacturer performs a finished goods inspection in a wafer state or a diced chip state once a step for forming the radio tuner part 30 and the electronic radio tuning control part 32 on a wafer is complete. In the finished goods inspection step, not only is the operation of the tuner system IC 20 checked but preset data is written to the nonvolatile memory 62, using an electric signal fed from the semiconductor tester to an external connecting terminal of the tuner system IC 20.

For example, in the finished goods inspection, a variety of functions of the tuner system IC 20 are controlled using the buses 56, 72, whereby the adjustments are performed. The suitable storage value of the register 54 obtained from the adjustment can be written to the nonvolatile memory 62.

In particular, and despite being very expensive, the semiconductor tester used by the manufacturer can perform adjustments to the IC at a rate that is 100 or more times faster than an all-purpose measuring instrument controlled by a GPIB or the like, and can reduce the cost of manufacturing ICs. As a result, devices of this type are usually adopted by semiconductor manufacturers. On the other hand, whereas the manufacturers of the sets and tuners introduce the device in order to set the nonvolatile memory 62, the large capital expenditure becomes a contentious issue.

In other words, adjusting the tuner system IC 20 is more readily performed by the semiconductor manufacturer using a semiconductor tester than by the manufacturer of the set or the like. Also, having the adjustments performed by the semiconductor manufacturer allows the manufacturer of the set or the like to eliminate the adjustment step; and, if the tuner system IC 20 is mounted on a substrate, to construct a tuner that satisfies the standards and the desired characteristics without performing any adjustment themselves.

In a case where a tuner system IC 20 having different standards and characteristics must be manufactured, the program of the semiconductor tester can be changed according to the standards or other specifications, the value of the register 54 can be changed, and the adjustments can be performed.

According to the present invention as described above, a radio tuner part and a controller are constructed as a single IC; consequently, in the step for manufacturing the IC, preset data for setting the operation of the radio tuner to a suitable state can be stored in the memory of the controller. In other words, the adjustments are performed by the IC manufacturer, allowing the manufacturers of the set and tuner not to have to perform them. The writing of the preset data to the memory can be performed when the finished goods inspection of the IC is performed, and can be executed at a throughput that accords with the processing speed of the semiconductor tester used in the finished goods inspection. Semiconductor testers used in the finished goods inspection step are generally high-speed testers, so the work associated with adjusting the ICs that will constitute the radio tuner system can be performed rapidly.

## Claims

1. A method for manufacturing the semiconductor device for use in a radio tuner, wherein:
a radio tuner part (30) and a controller (32) for controlling an operation of the radio tuner part (30) are built in a single semiconductor package;
the radio tuner part (30) has an adjustment register (54) for adjusting a predetermined function of the radio tuner part (30) according to stored data; and
the controller (32) has a memory (62) for pre-recording preset data for the adjustment register (54), and a control part (60) for reading out the preset data from the memory (62) at the start of operation of the radio tuner part (30) and for storing the data in the adjustment register (54);
the method comprising:
a packaging step for building the radio tuner part (30) and the controller (62) into the semiconductor package; and
a finished goods inspection step for performing, after the packaging step, a finished goods inspection for determining whether the semiconductor device operates satisfactorily or unsatisfactorily using a semiconductor tester; wherein
the finished goods inspection step involves checking an operation of the semiconductor device, and the preset data being written to the memory (62), according to an electrical signal fed from the semiconductor tester to a terminal of the semiconductor package.

2. A method for manufacturing the semiconductor device for use in a radio tuner, wherein:
a radio tuner part (30) and a controller (32) for controlling an operation of the radio tuner part (30) are built in a single semiconductor chip;
the radio tuner part (30) has an adjustment register (54) for adjusting a predetermined function of the radio tuner part (30) according to stored data; and
the controller (32) has a memory (62) for pre-recording preset data for the adjustment register (54), and a control part (60) for reading out the preset data from the memory (62) at the start of operation of the radio tuner part (30) and for storing the data in the adjustment register (54);
the method comprising:
a finished goods inspection step for performing a finished goods inspection for determining whether the semiconductor device operates satisfactorily or unsatisfactorily using a semiconductor tester, after the radio tuner part (30) and the controller (32) are formed on a common semiconductor substrate; wherein
the finished goods inspection step involves checking an operation of the semiconductor device, and the preset data being written to the memory (62), according to an electrical signal fed from the semiconductor tester to a terminal of the semiconductor device.

## Patentansprüche

1. Verfahren zum Herstellen der Halbleitervorrichtung zur Verwendung in einem Radio-Tuner, wobei
ein Radio-Tunerteil (30) und eine Steuerung (32) zum Steuern eines Betriebs des Radio-Tunerteils (30) in einer einzelnen Halbleiterpackung eingebaut werden;
der Radio-Tunerteil (30) ein Einstellregister (54) zum Einstellen einer vorbestimmten Funktion des Radio-Tunerteils (30) entsprechend gespeicherten Daten aufweist;
die Steuerung (32) einen Speicher (62) zum im voraus Aufzeichnen von voreingestellten Daten für das Einstellregister (54) und einen Steuerteil (60) zum Auslesen der voreingestellten Daten aus dem Speicher (62) bei einem Start des Betriebs des Radio-Tunerteils (30) und zum Speichern der Daten in dem Einstellregister (54) aufweist;
wobei das Verfahren aufweist:
einen Packschritt zum Einbauen des Radio-Tunerteils (30) und der Steuerung (62) in der Halbleiterpackung;
einen Endproduktinspektionsschritt zum Durchführen einer Endproduktinspektion nach dem Packschritt unter Verwendung eines Halbleitertesters, um zu bestimmen, ob die Halbleitervorrichtung zufrieden stellend arbeitet; wobei
der Endproduktinspektionsschritt ein Überprüfen eines Betriebs der Halbleitervorrichtung und der voreingestellten Daten, die in den Speicher (62) geschrieben sind, entsprechend einem elektrischen Signal, das von dem Halbleitertester einem Anschluss der Halbleiterpackung zugeführt wird, beinhaltet.

2. Verfahren zum Herstellen der Halbleitervorrichtung zur Verwendung in einem Radio-Tuner, wobei
ein Radio-Tunerteil (30) und eine Steuerung (32) zum Steuern eines Betriebs des Radio-Tunerteils (30) in einem einzelnen Halbleiterchip eingebaut werden;
der Radio-Tunerteil (30) ein Einstellregister (54) zum Einstellen einer vorbestimmten Funktion des Radio-Tunerteils (30) entsprechend gespeicherten Daten aufweist;
die Steuerung (32) einen Speicher (62) zum im voraus Speichern von voreingestellten Daten für das Einstellregister (54) und einen Steuerteil (60) zum Auslesen der voreingestellten Daten aus dem Speicher (62) bei einem Start des Betriebs des Radio-Tunerteils (30) und zum Speichern der Daten in dem Einstellregister (54) aufweist;
wobei das Verfahren aufweist:
einen Endproduktinspektionsschritt zum Durchführen einer Endproduktinspektion zum Bestimmen, ob die Halbleitervorrichtung zufrieden stellend arbeitet, unter Verwendung eines Halbleitertesters, nachdem der Radio-Tunerteil (30) und die Steuerung (32) auf einem gemeinsamen Halbleitersubstrat ausgebildet wurden; wobei
der Endproduktinspektionsschritt ein Überprüfen eines Betriebs der Halbleitervorrichtung und der voreingestellten Daten, die in den Speicher (62) geschrieben sind, entsprechend einem elektrischen Signal, das von dem Halbleitertester einem Anschluss der Halbleitervorrichtung zugeführt wird, beinhaltet.

## Revendications

1. Procédé de fabrication du dispositif semi-conducteur à utiliser dans un syntoniseur radio, dans lequel :
une partie de syntoniseur radio (30) et un dispositif de commande (32) pour commander un fonctionnement de la partie de syntoniseur radio (30) sont incorporés dans un unique boîtier de semi-conducteur ;
la partie de syntoniseur radio (30) comprend un registre de réglage (54) pour régler une fonction prédéterminée de la partie de syntoniseur radio (30) en fonction de données stockées ; et
le dispositif de commande (32) comprend une mémoire (62) pour le pré-enregistrement des données de préréglage pour le registre de réglage (54), et une partie de commande (60) pour la lecture des données de préréglage à partir de la mémoire (62) au début du fonctionnement de la partie de syntoniseur radio (30) et pour stocker les données dans le registre de réglage (54) ;
le procédé comprenant :
une étape de mise en boîtier pour construire la partie de syntoniseur radio (30) et le dispositif de commande (62) dans le boîtier de semi-conducteur ; et
une étape d'inspection de produits finis pour effectuer, après l'étape de mise en boîtier, une inspection de produits finis pour déterminer si le dispositif semi-conducteur fonctionne de manière satisfaisante ou insatisfaisante en utilisant un testeur de semi-conducteur ; dans lequel
l'étape d'inspection de produits finis comporte une vérification d'un fonctionnement du dispositif semi-conducteur, et les données de préréglage étant écrites dans la mémoire (62), en fonction d'un signal électrique alimenté à partir du testeur de semi-conducteur sur une borne du boîtier de semi-conducteur.

2. Procédé de fabrication du dispositif semi-conducteur à utiliser dans un syntoniseur radio, dans lequel :
une partie de syntoniseur radio (30) et un dispositif de commande (32) pour commander un fonctionnement de la partie de syntoniseur radio (30) sont incorporés dans une unique puce de semi-conducteur;
la partie de syntoniseur radio (30) comprend un registre de réglage (54) pour régler une fonction prédéterminée de la partie de syntoniseur radio (30) en fonction de données stockées ; et
le dispositif de commande (32) comprend une mémoire (62) pour le pré-enregistrement des données de préréglage pour le registre de réglage (54), et une partie de commande (60) pour la lecture des données de préréglage à partir de la mémoire (62) au début du fonctionnement de la partie de syntoniseur radio (30) et pour stocker les données dans le registre de réglage (54) ;
le procédé comprenant :
une étape d'inspection de produits finis pour effectuer une d'inspection de produits finis pour déterminer si le dispositif semi-conducteur fonctionne de manière satisfaisante ou insatisfaisante en utilisant un testeur de semi-conducteur, après que la partie de syntoniseur radio (30) et le dispositif de commande (32) sont formés sur un substrat semi-conducteur commun ; dans lequel
l'étape inspection de produits finis comporte une vérification d'un fonctionnement du dispositif semi-conducteur, et les données de préréglage étant écrites dans la mémoire (62), en fonction d'un signal électrique alimenté à partir du testeur de semi-conducteur sur une borne du dispositif de semi-conducteur.
